# EUROPEAN PATENT APPLICATION

(11) **EP 2 166 577 A1**
(43) Date of publication of application: **24.03.2010**
(21) Application number: 08164942.8
(22) Date of filing: 23.09.2008
(51) Int. Cl.: H01L 31/055, H01L 31/032, H01L 31/075

(54) **Solar cell and method of manufacturing a solar cell**

(71) Applicant: Advanced Surface Technology B.V., 8912 AR Leeuwarden (NL)
(72) Inventor: Meester, Ben, 8927 AA Leeuwarden (NL); Nanu, Marius, 8927 AA Leeuwarden (NL)
(74) Representative: Hatzmann, Martin

(57) **Abstract**

A solar cell is provided with a down-converter that converts incoming high energy photons into two or lower energy photons before conversion to electric current, in order to provide for more efficient conversion. The down-converter comprises a combination of Neodymium and Ytterbium ions in a sulfide. The sulfide may ne Indium Sulfide, doped with the Neodymium and Ytterbium. The indium sulfide may be combined with a CIS (Copper Indium Sulfide layer to form active layers of a solar cell, or the sulfide with Neodymium and Ytterbium may be used as a separate filter before conversion to electric current. A solar cell may be provided with an up converter realized by means of quantum dots in an absorber matrix.

## Description

### Field

The invention relates to a solar cell and method of manufacturing a solar cell.

### Background

In solar cells the efficiency of the conversion of light into electric current is an important parameter. Conversion efficiency depends on the wavelength, or spectrum of wavelengths of incoming radiation. The bandgap energy of the semi-conductor material in which the conversion takes place determines a wavelength of optimal efficiency. The conversion involves use of the energy of incoming photons to transfer electrons and/or holes to cross the bandgap. For a direct transfer a photon with at least the wavelength corresponding to the bandgap energy is needed. Conventionally, light with higher wavelength cannot be converted and additional energy of photons with smaller wavelength only leads to dissipation that does not contribute to the current.

It has been suggested to increase the efficiency of use of lower wavelength photons by means of "quantum cutting', i.e. by the use of a material that converts high energy photons each into a plurality of lower energy photons. This has been published for example in an article by Vergeer et al., titled "Quantum cutting by cooperative energy transfer in YbxY1-xP04:Tb3+" and published in Physical Review B 71, 014119 (2005). Vergeer et al. mention the use of single ions such as Pr3+ Tm3+, and Gd3+ that produce a pair of photons on absorption of a single higher energy photon. Vergeer also mentions the possibility of using combinations of different types of ions as a donor and an acceptor. In this case the donor ion receives the incoming photon and energy of the donor ion is transferred stepwise to two acceptor ions. This process is generally known as down-conversion. Examples of known donor-acceptor combinations are Gd3+Eu3+ couples, Gd3+Er3+, Gd3+Tb3+Er3+, and Nd3+-Ce3+ and Tb3+-Yb3+. In all systems, high energy radiation is downconverted to visible radiation. Vergeer et al describe detailed measurements and predictions using Tb3+ - Yb3+ as donor and acceptors in a fluoride or oxide host. However, efficient quantum cutting in Tb3+ - Yb3+ requires a high concentration of Tb3+ - Yb3+, because it involves a second order transition, which has a low probability. As impurities Tb3+ - Yb3+, may have a disturbing effect. Furthermore, efficiency may be small because of radiation free decay of excited Terbium.

Not all rare earth elements lead to efficient quantum cutting. For unsuitable material choices, efficiency may be low because a considerable amount of radiation free relaxation occurs. Efficiency may also be low when the transitions involved in quantum cutting are forbidden. In this case the transitions depend on the availability of perturbation.

On the low energy side, it has been proposed to use material that enable electrons or holes to cross the bandgap of the main semi-conductor in two steps, each upon absorption of a respective photon. This is called up-conversion. To provide for up-conversion an additional semiconductor body is introduced on the solar cell, to provide for an intermediate conduction band at half the bandgap energy of the main semi-conductor. The intermediate band can be realized by means of nano-particles in the semi-conductor (quantum dots). Thus for example an absorber matrix with a bandgap of 2 to 2.2 eV can be provided with nano-particles with a bandgap of 1- 1.5 eV. This allows for the generation of mobile charge carriers in the absorber matrix by means of a two-photon excitation process, with an intermediate state in the bandgap of a nano-particle. An incoming photon with energy of 1-1.5 eV produces a charge carrier in the intermediate band and an incoming photon with energy of 0.5 to 1 eV uses this charge carrier to generate a charge carrier to the absorber matrix.

### Summary

### It is an object to increase the efficiency of solar cells.

In an embodiment a combination of Neodymium-Ytterbium is used to provide for quantum cutting. This combination has been found to be suitable to provide for quantum cutting. It provides for a first order quantum cutting decay process, because Neodymium has an excitation level in the right wavelength range and an intermediate level about halfway below the excitation level, which allows for efficient conversion of excitation of the excitation level to lower excited levels.

Preferably, a host with only relatively heavy elements is used, for example a metal sulfide host is, or a Phosphide or heavier element instead of Sulfur, for example using Chlorides or Bromides instead of Sulfides. The use of only heavy elements has the advantage that less radiation free decay of the excited levels occurs than in the case of oxides or fluorides.

The use of an Indium sulfide semiconductor as a host for the Neodymium-Ytterbium has the advantage that the conduction band can easily be placed slightly above the excitation level of Neodymium, which provides for efficient excitation of the Neodymium level.

In an embodiment, the Indium sulfide semiconductor with Neodymium and Ytterbium is used as one of the active layers of a solar cell. Thus no additional layer is possible. In a further embodiment an Indium Sulfide-CIS (Copper Indium Sulfide) solar cell may be used.

According to another aspect quantum dots are introduced in the semi-conductor material of one of the active layers of a solar cell to provide for up-conversion. The quantum dots provide for at least one intermediate band, which can be used to excite electrons and/or holes in the conduction band of the host semiconductor in a multistep process. In an embodiment an average dot size that varies with depth in the absorber matrix layer may be used. A plurality of layers with quantum dots of different sizes may be used for example. This makes it possible to use as broader part of the spectrum for up-conversion. In an embodiment, the solar cell with quantum dots is manufactured by mixing liquid host material with solid quantum dot particles and spraying the mix onto a substrate. A plurality of layers may be realized by successive spraying of mixtures with successively differently sized particles.

### Brief description of the drawing

Objects and advantageous aspects will become apparent from a description of exemplary embodiments, using the following figures.
- Fig. 1: shows neodymium en ytterbium sulfide absorption spectra and emission spectra of ytterbium doped neodymium sulfide
- Fig. 2: shows photoluminescence emission spectra
- Fig.3: shows an example of a solar cell
- Fig.4: shows levels and transitions in a bandgap
- Fig.5: shows a solar cell with layers of quantum dots

### Detailed description of exemplary embodiments

The inventors have found that a combination of Ytterbium and Neodymium doping may be used to provide for quantum cutting. Ytterbium doped Neodymium sulfide, or Neodymium doped Ytterbium sulfide may be used for example. In an example doping with a concentration in a range of zero to ten percent may be used. When irradiated by light, Neodymium is first excited. Relaxation of the excited level produces excitation of the intermediate level of the Neodymium and an excitation level of Ytterbium, which may both relapse under emission of a photon. Also the excited intermediate level of Neodymium may give rise to an additional excitation of Ytterbium at about the same level, which may relapse under emission of a photon.

It has been found that quantum cutting occurs in Ytterbium doped Zinc Sulfide. Zinc Sulfide has a bandgap of about 3.2 eV, which is limits efficiency use in terrestrial solar cells because terrestrial light comprises little intensity with sufficiently short wavelength to excite electrons across this bandgap, but such cells may be useful for solar cells in space. As an alternative Indium sulfide, Lanthanum sulfide and a family of Zinc Indium Sulfides (ZnₓIn₂S₃₊ₓ) may be used. Indium sulfide has been proven to be useful in solar cells. It can be deposited by cheap spray techniques and its bandgap can easily be tuned. A bandgap of 2.6 eV may be realized for example.

The inventors have first studied the relevant spectroscopic properties of Neodymium-Ytterbium for suitability in quantum cutting in pure Ytterbium sulfide and Neodymium sulfide. The results are expected to be representative for other host compositions because the 4f energy levels of rare earth material are hardly affected by their chemical context.

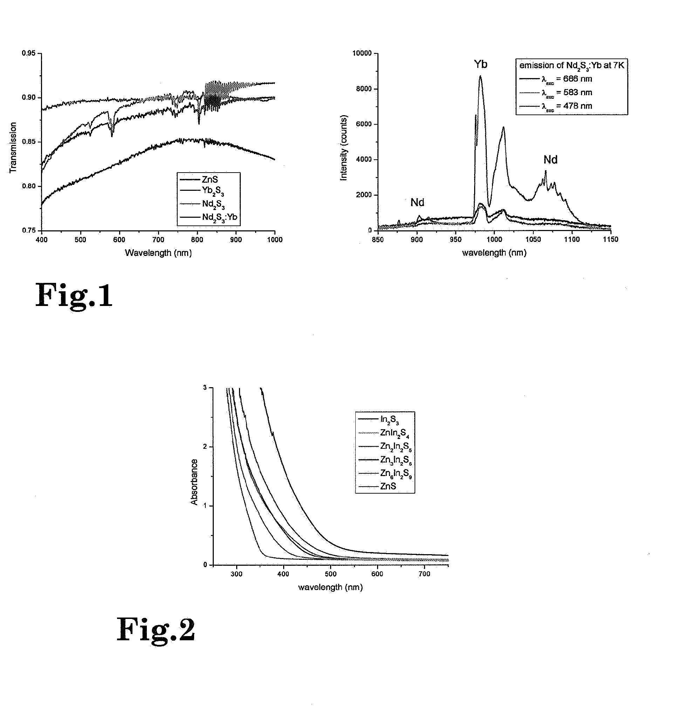

Figure 2 shows absorption spectra of Neodymium en Ytterbium Sulfide and emission spectra of ytterbium doped neodymium sulfide. For Ytterbium sulfide a weak absorption band was found at 975 nm. Neodymium sulfide composite absorption bands were found at 476, 525, 581, 684, 748 en 804 nm.

It is expected that these will be found at about the same place when Neodymium and Ytterbium are used as doping in a sulfide host. Synthetic doped Indium Sulfide layers may be realized by adding Ytterbium and Neodymium and annealing. In Yb doped indium sulfide or zincindiumsulfide layers quantum cutting may be based on impurity bound exiton emission from the host lattice to an excited state of the Yb-ion followed by a transition from this excited state to the ground state. An alternative possibility is to use excited states of two different adjacent rare earth ions as shown for Gd-Eu. Nd-Yb may also be used. As a demonstrator neodymium sulfide doped with ytterbium has been studied.

Figure 2a shows photoluminescence emission spectra of Yb doped Neodumium sulfide at 7K for different excitation wavelengths. At this temperature and excitation with 686 en 478 ytterbium emission at 975 and 1020 nm was found. For excitation with 527 of 583 nm light also emissions at 900 and 1064 nm were found, which may be attributed to neodymium. At room temperature at all four excitation wavelengths both ytterbium and neodymium emissions was found.

The experiments on ytterbium doped neodymium sulfide showed transfer from van neodymium to ytterbium, because after excitation in one of the Nd 4f levels clear Yb emission at 975 nm was present. Neodymium sulfide has no emission at this wavelength. The emission spectra after excitation of 4F9/2 (686 nm) of 4G11/2, 2P3/2, 2D3/2, 2G9/2 (476-480 nm) had identical levels and after excitation at the intermediate 4G5/2 (583 nm) and 4G9/2,7/2 (527 nm) the levels had a clearly different emission spectrum. This shows that during the relaxation after excitation of the 4G11/2, 2P3/2, 2D3/2, 2G9/2 levels to lower levels the intermediate 4G9/2,7/2 en 4G5/2 levels are skipped. The only explanation is that a large portion of energy is transferred elsewhere and excitation of the ytterbium ion is the only possibility. Because it was shown that excitation at 686 nm resulted in transfer of excitation energy to ytterbium this means that excitation of the 4G11/2, 2P3/2, 2D3/2, 2G9/2 levels results in the desirable two-step energy transfer from neodymium to ytterbium. The temperature dependent measurements show that the observed neodymium emission at room temperature is the result of thermally activated backtransfer from ytterbium to neodymium. At low temperature only ytterbium emission is observed.

Instead of a sulfide other compositions may be used, for example a phosphide, chloride or bromide. By using only heavy elements in the layer that contains the neodymium to ytterbium, the phonon spectrum can be made to reduce the rate of radiation free decay.

In an embodiment the Neodymium and Ytterbium may be used as doping ions introduced into a semi-conductor, to provide for quantum cutting. In an example doping with a concentration in a range of zero to ten percent may be used. In an embodiment Indium Sulfide may be used as the semi-conductor Indium Sulfide has a bandgap of about 2.6ev. To realize efficient quantum cutting a bandgap that is slightly larger than the excitation level of Neodymium is preferably used. Indium Sulfide provides about the right bandgap and bandgap tuning makes it possible to optimize the bandgap for quantum cutting. Neodymium and Ytterbium doped Indium Sulfide may be used on its own as a downconversion layer in front of a solar cell, or it may be used as one of the active layers of a solar cell. In either case, it is preferred that the bandgap of the layer of the solar cell that is used to convert the downconverted photons to electric current is lower that the energy of the photons produced by quantum cutting (about 1.3 eV in the case of Neodymium and Ytterbium). Copper Indium Sulfide (CIS) may be used for this layer. The bandgap of CIS is about 1.35ev. This bandgap can be tuned by adjusting the composition of the CIS layer and/or its crystal structure.

In a further embodiment Neodymium and Ytterbium doped Indium Sulfide and CIS may be used as active layers of a solar cell.

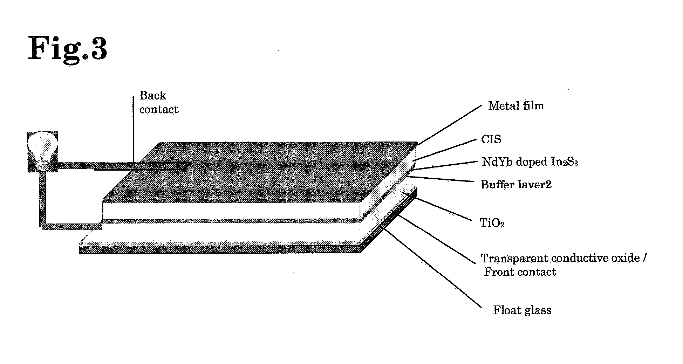

Figure 3 shows layers in an example of a solar cell. The solar cell successively comprises layers comprising a float glass substrate, a front contact, a transparent conductive oxide layer, a Ti02 layer, a buffer layer, an In2S3 layer, a CIS layer and a metal film. This type of solar cell is known per se. The In2S3 layer and the CIS layer form the p and n type active layers of the solar cell. As used herein, the active layers of a solar cell are the layers that provide for the junction at which charge separation of excitations takes place to generate net electric current. Typically, these excitations are generated by absorption of photons in at least one of the active layers. To improve efficiency Neodymium and Ytterbium have been added as doping to the semi-conducting In2S3 active layer.

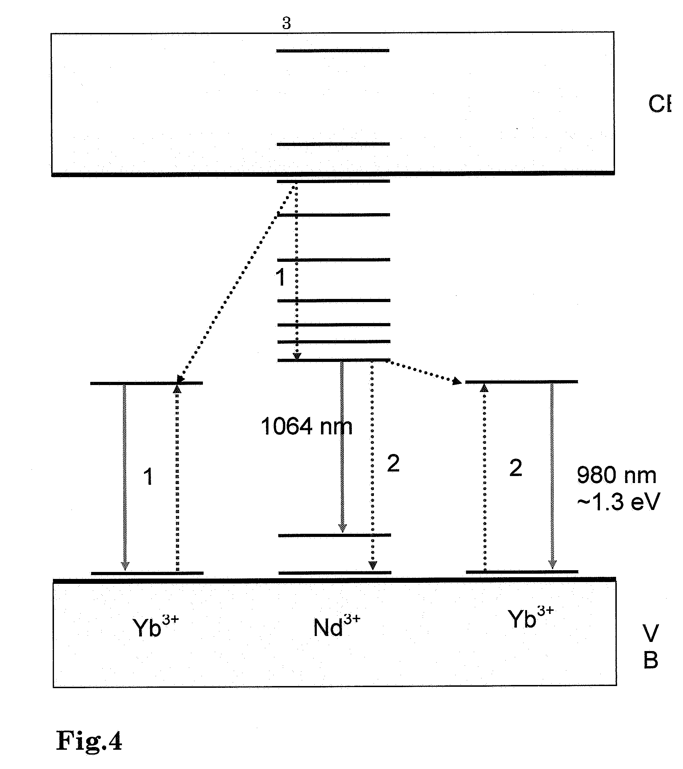

Figure 4 shows energy levels and transitions of Neodymium and Ytterbium between a conduction band CB and a valence band VB of a semi-conductor in more detail.

The use of these two bandgaps facilitates the implementation of quantum cutting. Preferably, the Indium Sulfide bandgap is adjusted to a level above that of the excitation level of Neodymium. Thus photons may be used to excite electrons in the conduction band of the semiconductor first, from which the electrons excite the Neodymium. Also preferably, the CIS bandgap is adjusted to a level just below of the energy of the photons produced by quantum cutting due to Neodymium and Ytterbium. The bandgaps of Indium Sulfide and CIS make such a combination possible.

In summary, the experiments show that the combination of Nd-Yb can provide for downconversion. This combination may provide for increased efficiency of CIS solar cells as well as Si solar cells or other solar cells. In the case of CIS solar cells the Neodymium- Ytterbium doped Indium sulfide may be used as one of the active layers of the solar cell, or it may be provided as a separate layer to provide for down-conversion. In Si solar cells it may be used as a separate layer.

Any technique may be used to provide for a host material with added Nd and/or Yb. Spraying may be used to deposit the sulfide host material, for example. Spraying has the advantage of providing for a low-cost manufacturing technique. It is desirable to obtain a uniform distribution of Nd en Yb in the sulfide. It has been found that simple spraying of a mixture of Nd en Yb in Indium Sulfide does not provide for a satisfactory such a uniform distribution. A subsequent diffusion step in the resulting solid state material may be used. It is known that diffusion processes occur efficiently from at least several hundred degrees below the melting point of the host. The melting point of In2S3 is about 1050 centigrade. Annealing at temperatures of about 600-700 centigrade may therefore be used. Preferably, such an anneal step is perform in a H2S or sulfur atmosphere to preserve the optical properties of Indium sulfide, i.e. to preserve the bandgap. Alternatively, ion beam implantation may be used to implant the Neodymium and/or Ytterbium. Of course, instead of spraying other techniques may be used to grow the host material.

For both quantum cutting processes Yttrium sulfide or Lanthanum with a tuned bandgap and absorption coefficient may be an alternative. La2S3 has a reported bandgap of 2.5 eV, which could be increased to 2.6eV by doping. Lanthanum is closely related to ytterbium and neodymium and has a comparable ion diameter, which makes incorporation of ytterbium and neodymium in a Lanthanum lattice easier. The resulting material may be considered as an n-type layer of a CIS cell.

To provide for improved efficiency on the high wavelength (low energy) side Quantum blended into an isolator material may be added. A layer of Quantum Dots in an insulator may be used to create an intermediate band in a way which is known per se. Dot size can be used to tune the level of this band. Dot sizes (diameters) from a range of 2 to 15 nm may be used for example. In an alternative embodiment a high band gap semiconductor layer may be used as an absorber matrix instead of the insulator. The band or bands realized with the Quantum Dots provide for multistep conversion wherein a plurality of photons is used to generate one electron in a higher energy conduction band in a plurality of steps. In addition, it may be used to increase the output voltage of the solar cell.

The Quantum Dots may be synthesized by colloidal chemistry. SnS, Cu2SnS3, Cu2SnS4 or PbS may be used in the quantum dots for example. In an embodiment any material wit a tunable bandgap between 0.5 and 0.9 times the bandgap of the insulator or high band gap semiconductor may be used. In an embodiment the absorber matrix with Quantum Dots is realized by means of spray deposition. This may involve preparing a liquid containing the absorber material plus the Quantum Dots as solid particles in the liquid and subsequently spraying the liquid onto a substrate.

In an embodiment the Quantum Dots are doped so that half the intermediate band is filled with electrons. As is well known, filling of a band depends on the location of the Fermi level. This level can be adapted by doping.

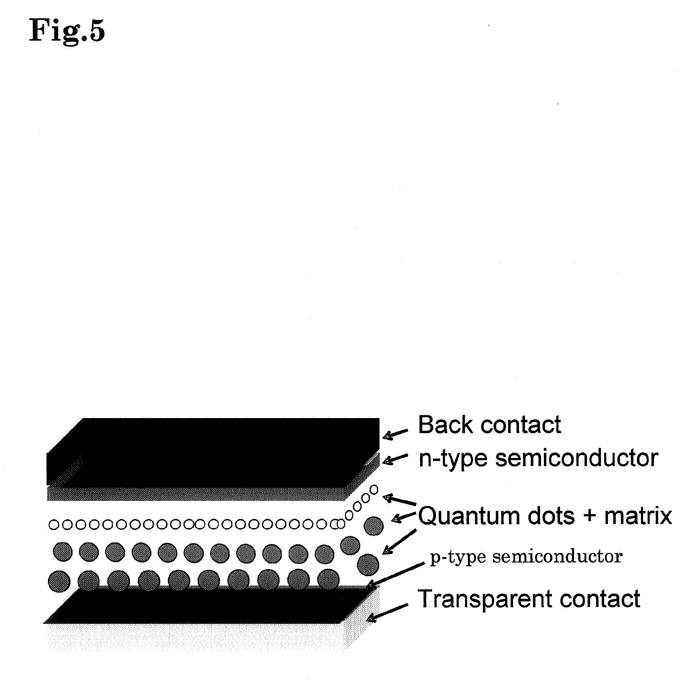

Figure 5 shows an embodiment of a solar cell wherein a plurality of layers is provided in an absorber matrix, each layer with quantum dots of a size that is specific to the layer. The solar cell successively comprises a transparent contact layer, an n-type semiconductor layer, an insulator or high band gap semiconductor, a p-type semiconductor layer, and a back contact. In an embodiment the absorber matrix layer is made of an isolator. The N-type semiconductor layer, the absorber matrix layer and the p-type semiconductor layer metal layers may form a PIN layer structure. Alternatively a semi-conductor material may be used as absorber matrix. Instead of n-type semiconductor layer and/or p-type semiconductor layer metal layers may be used to realize metal on semi-conductor junctions. Quantum dots are embedded in the absorber matrix layer. The average size of the quantum dots varies over the depth of the absorber matrix layer.

As schematically shown, in the illustrated embodiment the variation of the size defines a plurality of layers within the absorber matrix, each layer with quantum dots of a specific size. The sizes used for different layers are mutually different. Thus a plurality of intermediate bands at different levels may be realized. This provides for absorption from a wider part of the spectrum of incoming light. A first layer with quantum dots with a first average size of between 2 nm and 15 nm (e.g. 2 nm) may be used for example and a second layer with a different average size of between 2 nm and 15 nm (e.g. 15nm) may be used for example.

Preferably substantially dots with substantially identical size particular to the layer are used within a layer. Further layers with other sizes may be used in addition. In an embodiment manufacture of the solar cell comprises preparing liquids containing the absorber material plus the Quantum Dots as solid particles of respective average sizes and spraying the liquids successively onto a substrate.

In the illustrated embodiment, the size of the dots varies in steps as a function of the depth in the absorber matrix layer (from the n type semiconductor layer to the p-type semiconductor layer). In another embodiment the size of the quantum dots may be varied continuously as a function of the depth.

In the illustrated embodiment effectively a metal-semiconductor junction is used to generate the current for the excitations produced by the incoming light. Thus a solar cell is realized from two semiconductor materials (n and p-type) with the matrix with the Quantum DOTs in between.

A heterojunction structure may be used. Indium sulfide and CIS layers may be used in a heterojunction structure for example. When two semi-conductor layers are used as active layers, the quantum dots may be included in an isolator layer or a semiconductor with high band gap.

The quantum dots may be used irrespective of whether down conversion is used (for example with Neodymium Ytterbium). When down-conversion is used, it is preferred to put the doping in the layer with the highest bandgap and the quantum dots in an added isolating layer or in the layer with the lowest bandgap, for example down-conversion doping such as Neodymium Ytterbium in the Indium Sulfide layer and quantum dots in the CIS heterojunction. In this case quantum dots of a single size may suffice, but a quantum dot size that varies with depth is used. This increases efficiency.

The upconversion with the assistance of quantum dots is compatible with down conversion using quantum cutting. Thus a combination of both may be used to realize a highly efficient solar cell. Such cells can be manufactured using low cost manufacturing techniques like spray deposition.

## Claims

1. A solar cell, comprising a down-converter, the down-converter comprising a combination of Neodymium and Ytterbium in a sulfide composition.

2. A solar cell according to claim 1, wherein the sulfide composition is Indium Sulfide, doped with the Neodymium and Ytterbium.

3. A solar cell according to claim 2, having a first and second active layer and output terminals coupled to the first and second layer, and wherein the Indium Sulfide doped with the Neodymium and Ytterbium is used as one of the active layers.

4. A solar cell according to claim 3, wherein CIS is used as the other one of the active layers.

5. A solar cell according to claim 2, having first and second active layers and output terminals coupled to the active layers, wherein the sulfide composition containing Neodymium and Ytterbium is placed between at least one of the active layers and a plane through which incoming light reaches at least one of the active layers..

6. A method of manufacturing a solar cell, comprising providing a Neodymium and Ytterbium doped sulfide layer as a down-converter in the solar cell.

7. A method according to claim 6, comprising providing a liquid containing a sulfide and added Neodymium and Ytterbium and spraying the liquid onto a substrate to form the Neodymium and Ytterbium doped sulfide layer.

8. A method according to claim 6 or 7, comprising annealing the Neodymium and Ytterbium doped sulfide layer.

9. A solar cell comprising an absorber matrix layer comprising quantum dots providing for an intermediate band, an average size of the quantum dots in quantum dots varying with depth in the absorber matrix layer.

10. A solar cell according to claim 9, wherein the absorber matrix layer comprises a plurality of sub-layers at respective depths in the absorber matrix layer, each sub-layer comprising quantum dots of a respective average size.

11. A solar cell according to claim 9, comprising quantum dots with sizes in a range from 2 to 15 nm.

12. A solar cell according to claim 9, comprising a layer of semiconductor material doped with quantum dots Neodymium and Ytterbium.

13. A solar cell according to claim 9, comprising a Neodymium and Ytterbium doped sulfide layer as an active layer.

14. A solar cell according to claim 12, comprising an Neodymium and Ytterbium doped indium sulfide layer and a CIS layer on mutually opposite sides of a junction, the CIS layer forming the absorber matrix layer.

15. A method of manufacturing a solar cell, comprising
- providing solutions of liquid absorber material, each containing solid quantum dots of a respective average size, the average size in different solutions being mutually different;
- spraying the solutions successively onto a substrate, to form successive layers with quantum dots of mutually different size.
